# EUROPEAN PATENT SPECIFICATION

(11) **EP 0 957 543 B1**
(45) Date of publication and mention of the grant of the patent: **03.09.2003**
(21) Application number: 98201573.7
(22) Date of filing: 12.05.1998
(51) Int. Cl.: H01R 43/20, H05K 13/04

(54) **A connector press block**
Steckverbinder Einpressblock
Bloc de presse pour connecteur

(43) Date of publication of application: 17.11.1999
(73) Proprietor: BERG ELECTRONICS MANUFACTURING B.V., 5222 AV s'-Hertogenbosch (NL)
(72) Inventor: Van den Aker, Cornelis G. J., 5253 BB Nieuwkuijk (NL)
(74) Representative: de Vries, Johannes Hendrik Fokke

(56) References cited:
- DE-A- 4 329 902
- US-A- 5 208 968
- US-A- 5 400 502

## Description

### Field of the Invention

The present invention relates to connectors and, more specifically, to a connector press block for use in an application device for through hole mount on a Printed Circuit Board (PCB) of a connector having press-fit type contact terminals.

### Background of the Invention

In modern PCB assembly lines connectors, such as connectors of the press-fit type, are applied on a PCB by automatic application machines. In general, such application means comprise one or a plurality of applicator heads bearing a press block having suitably shaped insertion members for inserting the contact terminals in through holes of the PCB.

Reference is made to the co-pending international patent applications "Method for positioning of at least one component on a printed circuit board, method for handling a component and device for carrying out such method" and "Device for pre-positioning components in a row for subsequent processing as well as such a method", assigned to the assignee of the present patent application, and which are herein incorporated by reference.

In the present description, the term press-fit contact terminals is generally used to designate a class of contact terminals having a retention section for holding and, in general, providing electrical contact with plated through holes of a PCB, including crimp type terminals.

The retention section is inserted in a through hole of a PCB by a suitably applied force on the contact terminals or the housing of the connector. The insertion force to be applied depends, among others, on the shape of the retention section of a press-fit contact terminal, the thickness of the contact terminal and the PCB, the diameter of the hole of a PCB and terminal and plating materials.

By way of reference, the press-fit insertion force for a standard connector module having four or five rows of each six contact terminals, such as the METRAL™ backplane connectors having a 2 mm square grid contact pitch, ranges from 30 tot 200 Newton for a single position or terminal. Hence, for a five row standard module having 30 contact terminals, the force to insert the connector into a PCB can be quite high, e.g. 600 kg/product. The press block used for the application of such a connector has to withstand an even higher force (say a factor 3 for safety) of up to and above 1500 kg for a standard connector module.

Further, connector modules may be end-to-end stackable on a PCB. That is, connector modules designed to be mounted side by side without loss of a contact position. In practical applications, several connector modules are applied end-to-end stacked, which even increases the force requirements of an automatic connector application machine.

Prior art press blocks, designed for providing an application force on the contact terminals, comprise a base or root from which a plurality of adjacently parallel spaced tab or fin type insertion members extend. At their free end, the insertion members have an application face for engaging the contact terminals and applying an insertion force thereon. For the application on a PCB of a standard module press-fit connector, each such insertion member engages all the adjacent contact terminals of a column or row. Dependent on the shape of a contact terminal, such as straight or right-angled, during insertion, part thereof is received between the spaced insertion members of the press block.

The space or gap between the insertion members is relatively small, because the insertion members apply an insertion force directly at the contact terminals. To prevent damages of the contact terminals during insertion of a connector on a PCB, in particular in the case of misaligned contact terminals, the insertion members of the press block require a very low surface roughness.

In view of the relatively high strength, design accuracy and low surface roughness requirements of the insertion members of such a press-fit press block, in practice, press blocks are machined by a rather expensive spark-erosion process from a block of metal, such as hardened machine tool steel. Those skilled in the art of machining techniques will appreciate that small tolerances and low surface roughness requirements of machined products are inversely proportional to the costs of manufacturing such products. Although expensive, spark-erosion has been proven to be an economically viable manufacturing process for the type of press-fit press blocks acting directly on the contact terminals.

Press blocks according to the preamble of claim 1 are disclosed, for example, in DE-A-43 29 902 and US-A-5 400 502. DE-A-43 29 902 discloses an insertion part for a press block, wherein the insertion force is exerted on shoulders on the contact terminals. US-A-5 400 502 discloses an apparatus for press-fitting a connector to a printed circuit board, comprising a magazine for accommodating a plurality of connectors for the printed circuit board, the connectors having a plurality of pins each with an outer diameter of an end portion smaller than an outer diameter of an intermediate portion, comprising an alignment block having alignment apertures each with a tapered entrance thereto and a diameter larger than the outer diameter of the end portion and smaller then the outer diameter of the intermediate portion.

Document US-A-5 208 968 discloses a programmable insertion tool for inserting a plurality of contact pins of a connector into respective openings in a substrate, comprising a body and a plurality of elongated members, each being in axial alignment with a respective one of said contact pins and having an end in abutting engagement with said respective one contact pin.

In applying the above press blocks, those skilled in the art will appreciate that insertion members acting on adjacent contact terminals will be in a force equilibrium, whereas insertion members at an end or outer position of the press block are asymmetrically loaded. This imbalance of forces at the outer ends results in a tendency of the end insertion members to deflect in outward direction with respect to their base. Besides the risk of an improper insertion force on the contact terminals, in practice, the deflection also results in tooling rupture and eventually breakage of end insertion members, requiring replacement of the rather expensive press blocks.

The risk of tooling rupture is even worse for press blocks designed for the insertion of end-to-end stackable connector modules. For the application on a PCB of a plurality of end-to-end stacked connector modules, in the applicator head of an application machine a plurality of press blocks are arranged in cascade. Due to the nature of end-to-end stacking, the end or outer insertion members of a press block have to be designed with a reduced thickness, in general less than half the spacing between adjacent contact terminals. This, such that the overall thickness of two adjacent end insertion members of adjacent press blocks is equal or less than the thickness of an insertion member in the centre part of a press block. By applying a single press block having such reduced end or outer insertion members, the risk of deflection and breakage of the end or outer members is relatively high.

### Summary of the Invention

It is an object of the present invention to provide an improved press block for the application of press-fit type connectors on a PCB with a reduced risk of deflection and rupture of the press block, thereby reducing the overall tooling costs of an application machine.

It is a further object of the present invention to provide a press block formed with an improved surface roughness, in order to further reduce the risk of damage of contact terminals, in particular the finished and/or plated contact ends thereof, thereby increasing the freedom of design of the press block.

It is another aspect of the present invention to provide a press-fit connector application device, comprising one or a plurality of the above improved press blocks.

According to the present invention, there is provided a press block for use in an application device for through hole mount on a Printed Circuit Board (PCB) of a connector having press-fit type contact terminals. The press block comprises a plurality of adjacently spaced insertion members having an application face for engaging the contact terminals and applying an insertion force thereon, and is characterized in that an insertion member at an end position of the plurality of insertion members, at its application face, connects by one or a plurality of reinforcement members to an adjacent insertion member.

With the reinforcement members according to the present invention, which connect an end or outer insertion member to its adjacent inner insertion member, the risk of deflection and rupture of an end insertion member is tremendously reduced. This, because the reaction forces by the contact terminals on an end or outer insertion member of the press block are effectively absorbed by the adjacent insertion member, providing an overall improved balance of forces and extended life cycle.

The position of the reinforcement members according to the present invention does not interfere with the requirement of end-to-end stackability of the press blocks. Because of its enhanced life cycle, the press block according to the invention reduces the overall costs of a connector application assembly line, not only with respect to reduced costs of replacement press blocks, but also due to the reduced number of stops of an application machine, resulting in a higher throughput of products.

Spark-erosion is a process wherein the metal product is immersed in a fluid electrolyte chemical bath and connected to one pool of an electrical power source, the other pool of which is connected to a movable electrode. Between the electrode and the product sparks are created resulting in locally removal of metal of the product. Although the required surface finishing is obtained by the spark-erosion process, the freedom of design of a product is limited by the shape of the electrode and the local replenishment of electrolyte. Impaired replenishment of electrolyte during the process negatively influences the dimensional accuracy and roughness consistency of the product. Accordingly, spark-erosion is a process which leans itself better for open slot-type constructions, such as the prior art press block disclosed above, providing a free flow of fluid.

Although the improved press block according to the present invention, with its required strength, dimensional accuracy and low surface roughness requirements can be produced, among others, by spark-erosion, the present invention provides for an improved manufacturing process of press blocks using Metal Injection Moulding (MIM) wherein a composite of a polymer mixed with fine grain metal is injection moulded, providing an intermediate or semi-finished press block. The polymer of the product thus obtained is depleted by heating the moulded product, followed by sintering and hardening to obtain the ultimate press block. The mechanical strength properties of such a press block resemble the spark-eroded machined metal tooling, while providing an improved low surface roughness against the same or less production costs. Accordingly, within the content of the present patent application, MIM is an economically more viable and favourable production process for press blocks.

Due to the moulding type process of MIM, the freedom of design is greatly enhanced compared to the spark-erosion process. Accordingly, press blocks can be provided to cater a wide variety of application requirements, e.g. signal, power, coax and customized connector modules. Each optimally designed and shaped according to the invention to withstand thousands of application cycles without substantial damage of contact terminals, which is virtually impossible to achieve with the prior art press blocks.

In a further embodiment of the invention, an even enhanced mechanical strength is achieved by mutually connecting, by reinforcement members, a plurality or all of the insertion members of a press block at their application face. It will be understood that the reinforcement members have to be positioned, such that no interference is provided with a proper insertion of contact terminals nor in that the risk of damage of contact terminals is increased.

In a yet further embodiment of the press block according to the invention, wherein the insertion members comprise parallel spaced tabs or fins, the reinforcement members comprise struts extending transverse to the parallel tabs. Such struts may be provided at one or each longitudinal edge of the insertion members and/or transverse at the surface part of the insertion tabs.

In a preferred embodiment of the improved press block according to the invention, in particular for the insertion of straight contact terminals, the mutually connected insertion members comprise an application face having the form of an application or load bearing cellular surface comprising an array of apertures for receiving the contact terminals. Such a "closed" structure provides for a greatly enhanced mechanical strength and hence number of application cycles compared to the prior art press blocks having a "split" or "open" structure, i.e. wherein the insertion members at their application face do not connect.

Preferably, the press block comprises a housing of which the application or load bearing surface is formed by a peripheral surface of the housing. Using MIM, the application or load bearing surface can be of a relatively small thickness preventing as much as possible damage of misaligned or loosely seated contact terminals in a connector module.

In particular with respect to a press block having an application surface or load bearing surface acting on the contact terminals of a connector, machining thereof by spark erosion to obtain the required surface roughness, is a very complicated and costly process of tooling manufacturing connecting to MIM.

For the purpose of positioning a press-fit connector, such as a receptacle connector for mounting on a PCB, the housing may comprise external means for holding and positioning of the connector at the press block. These external means can be advantageously designed and positioned to fit with existing receptacle connectors and for positioning and guiding of the press block with regard to the contact terminals of the connector. This, to even further reduce the risk of damage of the contact terminals by scratching or otherwise touching of the contact terminals and the press block.

For use in a press-fit connector application device, such as disclosed in the co-pending international patent application entitled " Method for positioning of at least one component on a printed circuit board, method for handling a component and device for carrying out such method", the press block according to the invention can be provided with means for mounting thereof in an application machine for through hole PCB mount of a press-fit connector.

A press-fit connector application device comprising an improved press block as disclosed above, forms part of the present invention.

The above and other features and advantages of the present invention will be readily apparent to one of ordinary skill in the art from the following written description when read in conjunction with the drawings in which like reference numerals refer to like elements.

### Brief Description of the Drawings

Figure 1 shows, in a schematic and illustrative manner, in exploded view, part of a prior art application device for the application of press-fit connectors on a Printed Circuit Board (PCB).
Figure 2 shows, in a schematic and illustrative manner, a plurality of press blocks shown in fig. 1, end-to-end stacked.
Figure 3 shows, in a schematic and illustrative manner, partly broken, end-to-end stacked press-fit connector modules before application thereof on a PCB.
Figure 4 shows, in a schematic and illustrative manner, a side view of another prior art press block.
Figure 5 shows, in a schematic and illustrative manner, a plurality of press blocks shown in fig. 4 adjacently mounted in an end-to-end stacked fashion.
Figure 6 shows, in a schematic and illustrative manner, partly broken, the press block shown in fig. 4 inserted in a receptacle press fit connector, applied on a PCB.
Figure 7 shows, in a schematic and illustrative manner, a preferred embodiment of the improved press block according to the present invention, from its application surface.
Figure 8 shows, in a schematic and illustrative manner, a sectional view of the press block shown in fig. 7 along the line VIII-VIII thereof.
Figure 9 shows, in a schematic and illustrative manner, a cross sectional view of the press block shown in fig. 7, inserted in a receptacle press-fit connector.
Figure 10A shows, in a schematic and illustrative manner, on an enlarged scale, the surface of an insertion member machined by spark-erosion.
Figure 10B shows, in a schematic and illustrative manner, the surface of an insertion member produced from Metal Injection Moulding (MIM) according to the present invention.
Figure 11 shows, in a schematic and illustrative manner, in perspective view, an improved press block according to the present invention for use with a right-angled press-fit connector.

### Detailed Description of the Embodiments

In the following description, for purposes of explanation and not limitation, specific details are set forth, such as particular designs, components etc. in order to provide a thorough understanding of the invention. However, it will be apparent to one of ordinary skill in the art that the present invention may be practised in other embodiments that depart from these specific details.

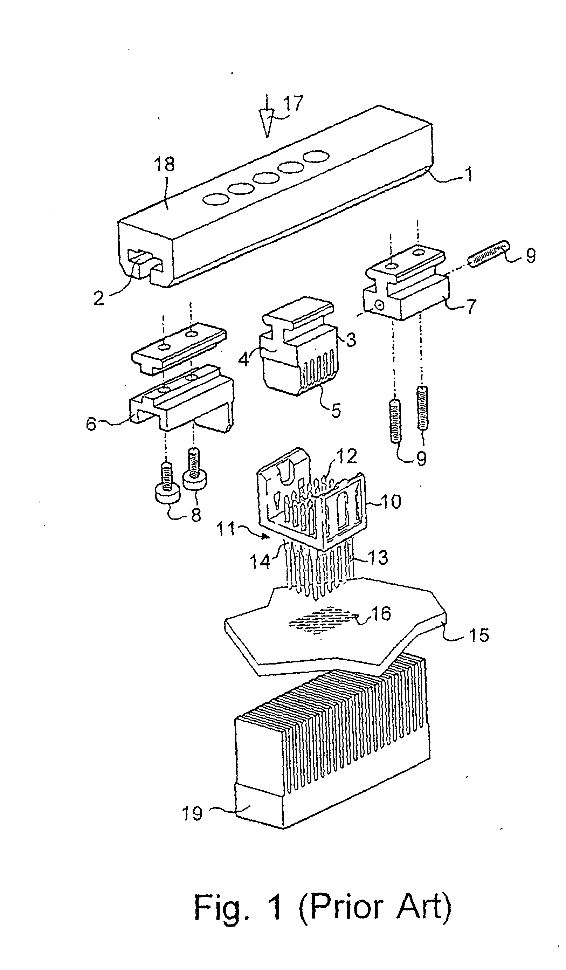

Fig. 1 shows, in a schematic and illustrative perspective view part of a prior art press-fit tooling set of a press-fit connector application machine comprising an applicator head or press block unit 1.

The applicator head 1 comprises a T-shaped slot or groove 2 for slidingly receiving a correspondingly T-shaped mounting part or base 4 of a press block 3. From the base 4 parallel spaced tab or fin type insertion members 5 extend. The press block 3 can be positioned in the applicator head 1 by clamp means 6, 7 which engage the applicator head 1 on both sides of the press block 3. The clamp means 6, 7 can be fixedly positioned in the applicator head 1 by screws and bolts 8, 9 respectively.

In the figure a receptacle connector 10 is shown, comprising a plurality of press-fit terminals 11, having a contact end 12, a connection end 13 and a press-fit section 14 positioned between the contact end 12 and the connection end 13 for through hole mount in a through hole 16 of a Printed Circuit Board (PCB) 15.

In use, the applicator head 1, with the press block 3 mounted therein, receives an insertion force at its upper surface 18 in the direction of the arrow 17. The PCB 15 is rigidly supported by a PCB support member 19, forming part of the press-fit connector application machine.

During insertion, the press block 3 with its insertion members 5 engage the contact terminals 11 from their contact end 12. After suitable positioning of the contact elements 11, i.e. their contact ends 13 with respect to the holes 16 of the PCB, an insertion force in the direction of the arrow 17 is applied at the contact terminals 11 by the insertion members 5 of the press block 3. This to insert the press-fit section 14 of the contact terminals 11 in the corresponding through hole 16 of the PCB 15. Thereafter, the press block 3 is retracted and the insertion, positioning and press-fit cycle is repeated for a next connector 10.

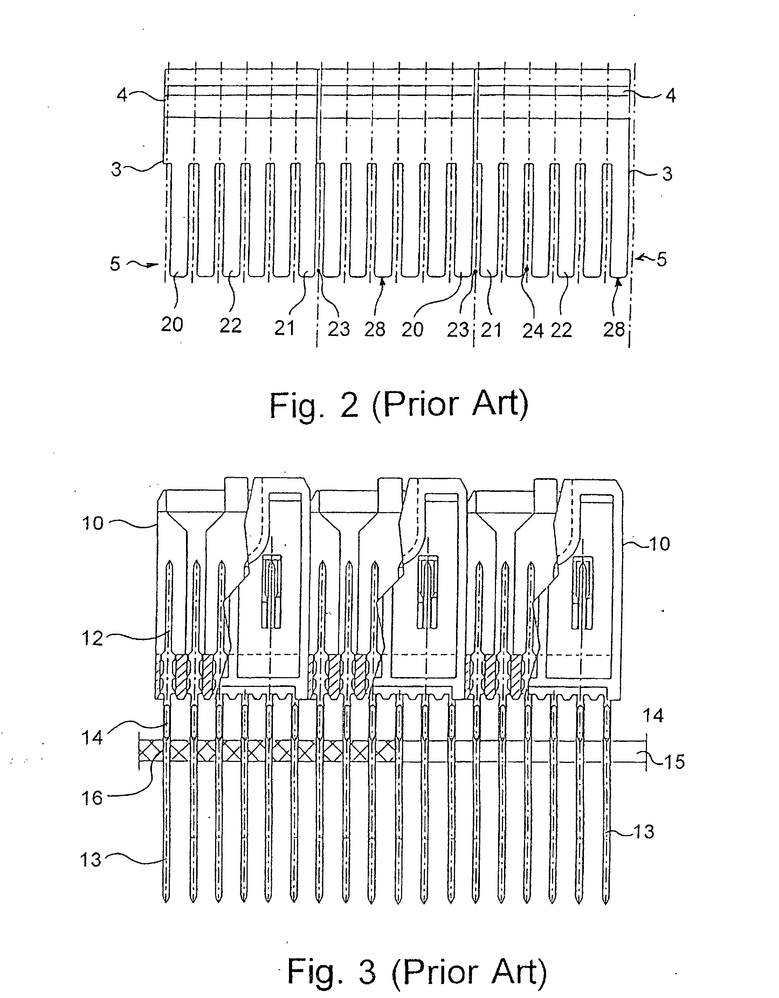

Fig. 2 shows three press blocks 3 of figure 1, side by side arranged in a end-to-end fashion for the insertion of three connector modules 10 end-to-end stacked as shown in fig. 3. That is, the spacing 23 between opposite insertion members 20, 21 is equal to the spacing 24 between insertion members 22 in the centre of the press block 3.

Fig. 3 shows, in a partly broken fashion, three connector modules 10, positioned in a end-to-end stacked manner on the PCB 15. The connectors 10 are shown prior to their application on the PCB 15 by the press block arrangement of fig. 2.

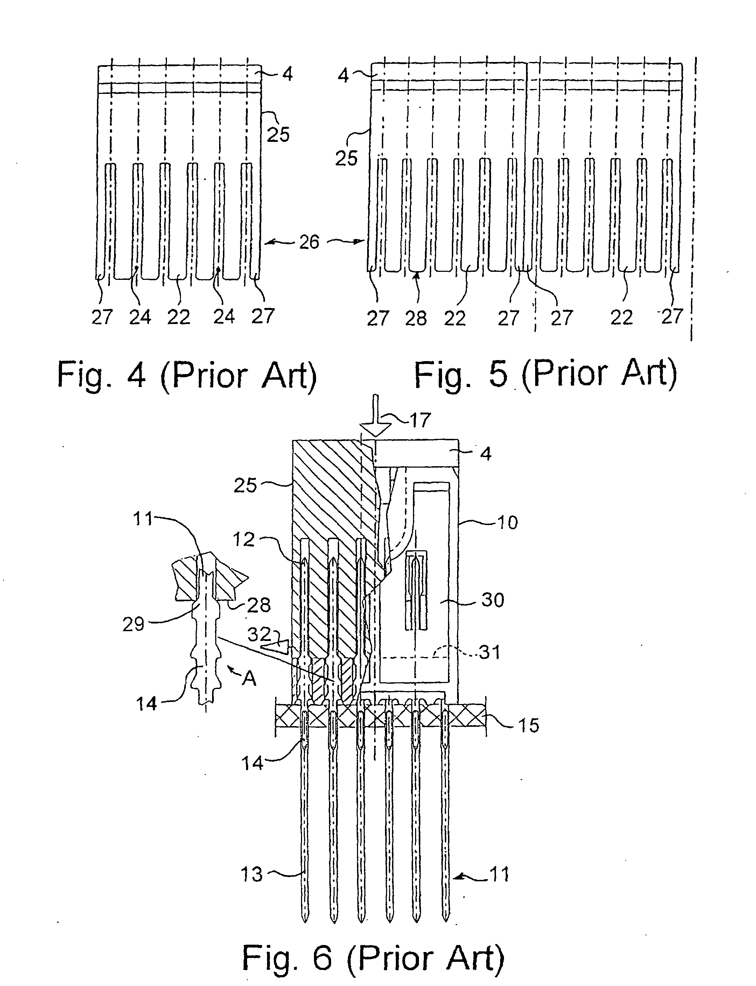

Fig. 4 shows a front view of another prior art press block 25, comprising parallel spaced tab or fin type insertion members 26 extending from a base or root 4. The difference between the press block 3 shown in figures 1 and 2 and the press block 25 comprises end or outer insertion members 27 having a thickness equal or less than half the thickness of the centre insertion members 22. This to provide end-to-end stackability of press blocks 25, as shown in figure 5.

In fig. 5, it can be viewed that the overall thickness of oppositely arranged end insertion members 27 equals the thickness of the middle insertion members 22.

Fig. 6 shows, in a partly broken view, the press block 25 inserted in a connector 10, in its position after application on the PCB 15.

As can be seen from fig. 6, the contact terminals 11, with their contact end 12, are received in the space 24 between the insertion members 26 which, with their application face 28 at the free end of the insertion members 26 engage the contact terminals 11 at slanting shanks 29 thereof, as more clearly shown in the enlarged detailed view A in fig. 6.

The slanting shanks 29 of the contact terminals 11 extend beyond and above the bottom 31 of the housing 30 of a connector 10. Accordingly, the insertion force applied by the insertion face 28 of the insertion members 26 acts directly on the contact terminals 11, i.e. their slanting shanks 29 of the press-fit section 14 and not on the plastic housing 30 of the connector 10. Accordingly, the force for press-fit application of the connectors 10 is directly applied by the press block 25 on the individual terminals 11 rather than indirectly via their plastic housing 30.

The middle insertion members 22 in fig. 6 act with their insertion face 28 on both sides at a contact terminal 11. However, this is not the case for the end or outer insertion members 27. The forces of reaction of the shanks 29 of the contact terminals 11 act along more or less opposing vectors defined by the shank angle. Although there is a force equilibrium with regard to the insertion members 22 in the centre of the press block 25, this is not the case for the end insertion members 27 which experience a resulting torque or bending force in outward direction with respect to the base 4, schematically indicated by arrow 32. This imbalance at the outer insertion members 27 effectively results in a tendency of outward deflection of the end insertion members 27, with the risk of an improper insertion force applied to the respective outer contact terminals and rupture or breakage of the end insertion members 27 itself. The risk of breakage is further increased by the fact that the end insertion members 27 have to be produced with a reduced thickness in the case of end-to-end stackable press blocks 25.

For a press block 3 shown in fig. 2, if applied singly, an outward deflection torque is exerted on the end insertion members 21. Although the end insertion members 21 do not suffer from a reduced thickness, in practice, there is a substantial risk of tool breakdown.

As illustratively shown in fig. 6 the insertion members 26, during the insertion thereof, closely slide between the contact ends 12 of the contact terminals 11 such that the insertion faces 28 can engage the contact terminals 11 at their slanting shanks 29. In order to avoid damage of the contact ends 12, which in practice can be gold or other nobel metal plated contact ends, the insertion members 26 have to be provided with a highly finished surface having a low as possible surface roughness.

In practice, within economically feasible conditions, this is achieved by machining a block of metal using the spark-erosion process, as disclosed above. For this type of product, conventional machining techniques can only be applied at the expensive of extremely high manufacturing costs, rendering the product not economically viable. Press blocks manufactured by conventional machining techniques are generally used for providing an insertion force on the connector housing, i.e. not on the contact terminals itself. Those skilled in the art will appreciate that applying the insertion force on the connector housing involves a great risk of damage.

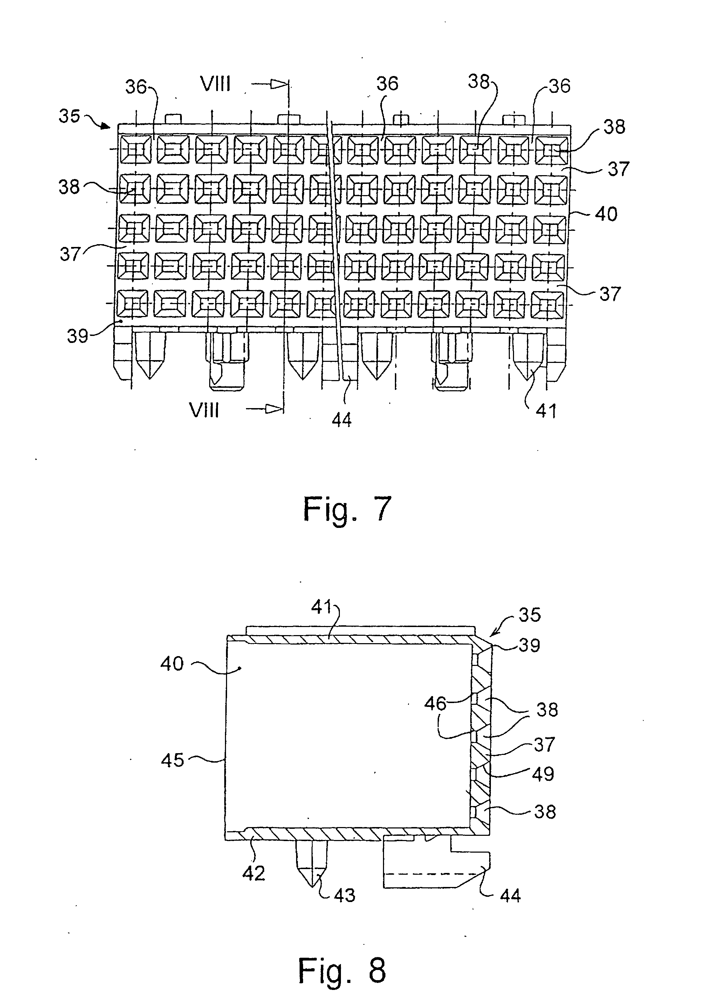

Figure 7 shows a front view of an improved press block 35 according to the present invention, wherein the insertion members, such as the insertion members 36 are mutually connected by reinforcement members 37 providing an insertion face having a cellular shape, i.e. an application surface 39 comprising a plurality of apertures 38.

The reinforcement members 37, comprising connecting struts which connect adjacent insertion members 36 transverse or perpendicular at their application face, act to balance the forces of reaction on the application surface 39 by the contact terminals 11 during insertion thereof in a PCB 15.

The increased mechanical strength of this cellular or "closed" press block 35, compared to the "open" or "split" press blocks 3, 25 as shown in figs. 2 and 5, respectively, results in an enhanced life cycle and a lesser risk of rupture or breakage of the end or outer insertion members 40 which, like the end insertion members 27 of the press block 25, may have a reduced thickness for end-to-end stackability of the press blocks 35.

Reinforcement members 37 connect an end insertion member 40 with its adjacent insertion member 36 at their application face. With such reinforcement members 37, during insertion of a press-fit connector, the outward deflective force at the end insertion members 40 is effectively transferred and absorbed by the adjacent insertion members 36. Those skilled in the art will appreciate that an improvement is already achieved by reinforcement members 37 provided at one or both of the edges of the insertion members 36, 40 and/or positioned at the surface area of the insertion members 36, 40. That is, the insertion members 36 may be shaped like the insertion members 5, 26 of figures 2 and 4, respectively.

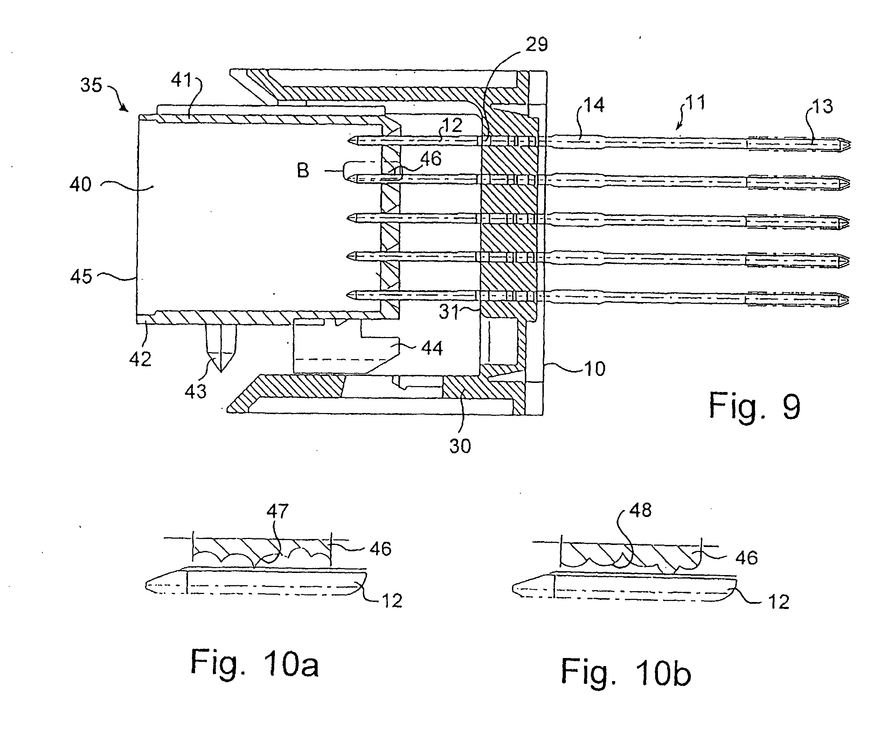

In fig. 8, showing the cross section view along the line VIII-VIII of figure 7, the closed or housing structure of the press block 35 becomes evident, i.e. comprising side walls 41, 42 connecting to the application surface 39 and the end insertion members 40. Due to the improved structural strength of the-press block 35 according to the invention, the insertion members 36 do not have to extend along the width of the side walls 41, 42. Hence, as shown, the insertion members 36 can be provided with a greatly reduced length, which reduces the risk of damage of the contact terminals 11, in particular skew or misaligned or loosely seated contact terminals in a connector module when the press block 35 is inserted along the contact ends 12 thereof, as illustratively shown in figure 9.

The apertures 38, i.e. the insertion face of the insertion members 36, 40 are provided with a suitable shape for engaging the shanks 19 of a contact terminal 11, such as a funnel-shape or outwardly flared 49, leaving a very small area or thickness 46 of the application surface 39 which is in close proximity to a contact terminal. That is, small with respect to the length of the contact terminal received by an aperture 38. Thereby minimizing the risk of damage of the nobel metal plated contact ends 12 of contact terminals.

As shown in figures 7 and 8, the housing of the closed press block 35, i.e. the side wall 42 thereof, can be provided with guiding and positioning means, such as the pins 43 and guiding lobes 44 for guiding and positioning of the press block 35 during its insertion in the connector 10. Illustrative shown in figure 9. The pins 43 and guiding lobes 44 may be adapted to a particular type of connector. Further, at the back 45 of the press block 35, means for mounting in an application head 1 can be provided, such as the base 4 in figure 1. Of course other suitable mounting means are feasible.

The press block 35, i.e. its apertured application surface 39, is extremely complicated and hence economically not viable to manufacture by spark-erosion. According to the invention, the press block 35 or a less complicated structure, such as in which only the insertion members 36 and 40 connect by reinforcement members 37, can be advantageously manufactured by a Metal Injection Moulding (MIM) process.

MIM is a process wherein a composite of a polymer is mixed with fine grain metal (like steel or titanium) and is injection moulded to provide an intermediate or semi-finished press block. In a next step, the product is heated at a temperature of about 140 to 150 °C to deplete the polymer. The ultimate product is than obtained by sintering and hardening steps. The mechanical strength properties of the thus formed press block resembles a machined metal tooling. Since the initially moulded material comprises almost 30% polymer, which is subsequentially driven-off during formation of the final product, part shrinkage and temperature control during the process defines the dimensional accuracy of the final product. It has been found that an end product with a required tolerance of about 0.05 mm can be obtained with a surface roughness which is even less than a spark-eroded machined press block, without increasing the production costs.

For comparison purposes figure 10A shows, on an enlarged scale, detail B of figure 9 of the surface 46 of a press block machined by spark-erosion. As illustrated, spark-erosion provides a "concave" surface profile 47.

Figure 10B shows, on a enlarge scale, detail B of the surface 46 of a press block manufactured by MIM. Such a moulded (MIM) tooling obtains a "convex" surface profile 48. It will be apparent that a convex surface roughness results in a reduced risk of damage to the mating contact ends 12 of the contact terminals 11 compared to the concave surface roughness of the spark-eroded press block.

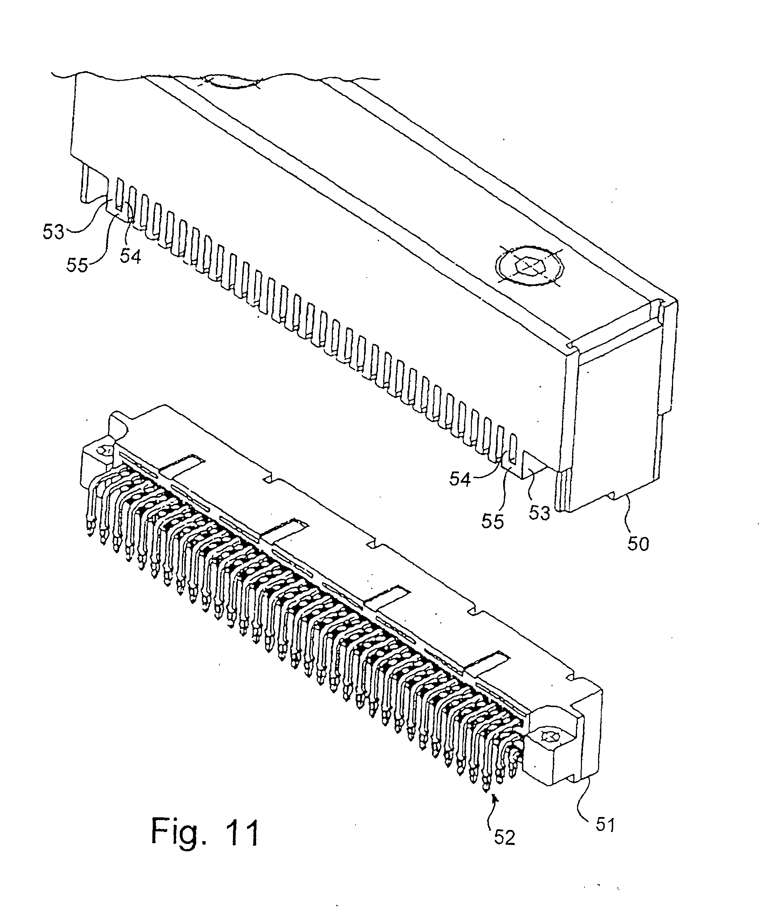

Figure 11 shows a press block 50 for use with a connector 51 having right-angled press-fit contact terminals 52.

According to the present invention, the end insertion members 53 of the press block 50 connect by a transverse strut-like reinforcement member 55 to their adjacent insertion member 54. The reinforcement members 55 are positioned at the outer edge of the insertion members 53, 54. The press block 50 can be provided either by spark-erosion or, according to the invention, by a MIM process.

Although the invention has been described and illustrated with respect to a preferred embodiment, comprising an apertured application surface and pin-type contact terminals, the novel and inventive idea can be applied with the same advantages for a plurality of connectors having other than pin-type contact terminals and differently shaped housings. Such as power and coax contact terminals having flat and circular shapes, respectively.

Tests have shown that the press block according to the invention, due to its enhanced mechanical strength, can be used with a variety of press-fit sections up to and including the well-known "H-shape" requiring an insertion force of about 100 N and connector modules of over 30 contact terminals.

## Claims

1. Press block (35) for use in an application device for through hole mount on a Printed Circuit Board (PCB) (15) of a connector (10) having press-fit type contact terminals (11), the press block (35) comprising a plurality of adjacently spaced insertion members (36) having an application face (39) for applying an insertion force on the contact terminals, wherein an insertion member (40) at an end of a row of insertion members (36), at its application face (39), connects by at least one reinforcement member(37) to an adjacent insertion member (36) **characterised in that** the application face(39) of an insertion member (36) defines an inclined aperture wall of a funnel or outwardly flared shape facing the corresponding inclined aperture wall of the application face (39) of an adjacent insertion member (36) for engaging the shanks (29) of the contact terminals (11).

2. A press block according to claim 1 , wherein said insertion members (36) comprise parallel tabs and wherein said reinforcement members (37) comprise connecting struts extending transverse to said parallel tabs.

3. A press block according to claim 2 , wherein said plurality of connected insertion members (36) comprise an application face (39) comprising an array of apertures for receiving contact terminals.

4. A press block according to claim 3, comprising a housing, a surface of which comprises said application face (39).

5. A press block (35) according to claim 3 or 4, wherein the length of a longitudinal section (46) of the funnel-shaped aperture wall for engaging said contact terminals is smaller than the length of a contact terminal (11) received by an aperture (38).

6. A press block according to claim 4 or 5 wherein said housing comprises end surfaces (40) arranged to provide for end-to-end stacking of press blocks (35), for the insertion of connectors (10) having dimensions, in terms of contact terminals, exceeding the dimensions of a single press block (35).

7. A press block according to claim 4,5 or 6, wherein said housing comprises external means (43,44) for holding and positioning of said housing into a receptacle connector prior to the mounting thereof on a PCB (15).

8. A press block according to claim 4,5,6 or 7 wherein said housing is provided with means (4) for mounting of said press block (35) in an application head of an application device for through hole PCB mount of a press-fit connector (10).

9. A press block according to any of the preceding claims, formed by Metal Injection Moulding (MIM) wherein a composite of a polymer mixed with fine grain metal is injection moulded, the polymer is depleted by heating from the moulded product, and the product thus obtained is sintered and hardened.

10. A press-fit connector application device, arranged for through hole mount on a printed circuit board (25) of a a press-fit type connector, said application device comprising a press block (35) according to any of the previous claims.

## Patentansprüche

1. Einpressblock (35) zur Verwendung in einer Anpressvorrichtung zur durchkontaktierenden Anbringung eines Steckverbinders (10), der Presspassungskontaktelemente (11) aufweist, auf einer bedruckten Leiterplatte (PCB), wobei der Einpressblock (35) mehrere im Abstand angeordnete benachbarte Einführungselemente (36) aufweist, die eine Anpressseite (39) aufweisen, um eine Einführungskraft auf die Kontaktelemente auszuüben, wobei ein Einführungselement (40) an einem Ende einer Reihe der Einführungselemente (36) an seiner Anpressseite zumindest ein Verstärkungselement (37) mit einem benachbarten Einführungselement (36) verbindet,
**dadurch gekennzeichnet, dass**
die Anpressseite (39) eines Einführungselements (36) eine abgeschrägte Öffnungswand eines Trichters oder eine nach außen konisch aufgeweitete Form definiert, die zur entsprechenden geneigten Öffnungswand der Anpressseite (39) eines benachbarten Einführungselements (36) gerichtet ist, um in die Schäfte (29) des Kontaktelements (11) einzugreifen.

2. Einpressblock nach Anspruch 1, wobei die Einfuhrungselemente (36) parallele Streifen aufweisen, und wobei die Verstärkungselemente (37) Verbindungsstreben aufweisen, die sich quer zu den parallelen Streifen erstrecken.

3. Einpressblock nach Anspruch 2, wobei die Vielzahl von verbundenen Einführungselementen (36) eine Anpressseite (39) aufweisen, die eine Gruppe von Öffnungen für die Aufnahme der Kontaktelemente aufweist.

4. Einpressblock nach Anspruch 3, der weiterhin ein Gehäuse aufweist, wobei eine Fläche von diesem die Anpressseite (39) aufweist.

5. Einpressblock (35) nach Anspruch 3 oder 4, wobei die Länge eines Längsabschnitts (46) der trichterförmigen Öffnungswand für den Eingriff in die Kontaktelemente schmaler als die Länge der Kontaktelemente (11) ist, die durch eine Öffnung (38) aufgenommen werden.

6. Einpressblock nach Anspruch 4 oder 5, wobei das Gehäuse Endflächen (40) aufweist, die eine Ende-an-Ende-Stapelung von Einpressblöcken (35) für die Einführung von Steckverbindern (40) ermöglicht, deren Kontaktelemente Größenordnungen aufweisen, die über die Anordnung eines einzelnen Einpressblocks hinausgehend.

7. Einpressblock nach Anspruch 4, 5 oder 6, wobei das Gehäuse äußere Einrichtungen (43, 44) aufweist, die das Gehäuse in einem Aufnahmesteckverbinder vor seiner Befestigung auf einer Leiterplatte (15) halten und positionieren.

8. Einpressblock nach Anspruch 4, 5, 6 oder 7, wobei das Gehäuse eine Einrichtung aufweist, die den Einpressblock (35) in einem Anpresskopf einer Anpressvorrichtung für die durchkontaktierende PCB-Anbringung eines Presspassungs-Steckverbinders (10) befestigt.

9. Einpressblock nach einem der vorstehenden Ansprüche, der durch Metallspritzguss (MIM) gebildet ist, wobei ein Verbundmaterial eines mit feinkörnigem Metall gemischten Polymers eingespritzt wird, wobei das Polymer durch Erwärmen von dem gegossenen Produkt entfernt wird, und das so erhaltene Produkt gesintert und gehärtet wird.

10. , Presspassungs-Steckverbinder-Anpressvorrichtung für die durchkontaktierende Anbringung eines Presspassungs-Steck verbinders auf einer bedruckten Leiterplatte (15), wobei die Anpressvorrichtung einen Einpressblock (35) nach den vorigen Ansprüchen aufweist.

## Revendications

1. Bloc de presse (35) susceptible d'être utilisé dans un dispositif d'application pour un montage, dans des trous traversants d'une carte de circuit imprimé (PCB) (15), d'un connecteur (10) ayant des bornes de contact (11) de type à ajustage à la presse, le bloc de presse (35) comprenant une pluralité d'organes d'insertion (36), espacés de façon adjacente, ayant une face d'application (39) pour appliquer une force d'insertion sur les bornes de contact, dans lequel l'organe d'insertion (40), à une extrémité d'une rangée d'organes d'insertion (36), par sa face d'application (39), est relié par au moins un organe de renfort (37) à un organe d'insertion (36) adjacent, **caractérisé en ce que** la face d'application (39) d'un organe d'insertion (36) définit une paroi d'ouverture inclinée, en forme d'entonnoir ou évasée vers l'extérieur, faisant face à la paroi d'ouverture inclinée correspondante de la face d'application (39) d'un organe d'insertion (36) adjacent afin d'engager les tiges (29) des bornes de contact (11).

2. Bloc de presse selon la revendication 1, dans lequel lesdits organes d'insertion (36) comprennent des encoches parallèles et dans lequel lesdits organes de renfort (37) comprennent des entretoises de liaison s'étendant transversalement auxdites encoches parallèles.

3. Bloc de presse selon la revendication 2, dans lequel ladite pluralité d'organes d'insertion (36) reliés comprend une face d'application (39) comportant une série d'ouvertures pour recevoir des bornes de contact.

4. Bloc de presse selon la revendication 3, comprenant un logement, dont une surface constitue ladite face d'application (39).

5. Bloc de presse (35) selon la revendication 3 ou 4, dans lequel la longueur d'une section longitudinale (46) de la paroi d'ouverture en forme d'entonnoir, pour engager lesdites bornes de contact, est plus petite que la longueur d'une borne de contact (11) reçue par une ouverture (38).

6. Bloc de presse selon la revendication 4 ou 5, dans lequel ledit logement comporte des surfaces d'extrémité (40) conformées pour assurer un assemblage bout à bout de blocs de presse (35), pour l'insertion de connecteurs (10) ayant des dimensions, en ce qui concerne les bornes de contact, qui dépassent les dimensions d'un bloc de presse (35) unique.

7. Bloc de presse selon la revendication 4, 5 ou 6, dans lequel ledit logement comprend d es m oyens externes (43, 44) p our le maintien et lep ositionnement dudit logement dans un socle de connecteur avant le montage de celui-ci sur une carte de circuit imprimé (15).

8. Bloc de presse selon la revendication 4, 5, 6 ou 7, dans lequel ledit logement est pourvu de moyens (4) pour le montage dudit bloc de presse (35) dans une tête d'application d'un dispositif d'application pour un montage, dans des trous traversants d'une carte de circuit imprimé, d'un connecteur (10) à ajustage à la presse.

9. Bloc de presse selon une quelconque des revendications précédentes, formé par moulage à injection de métal (MIN), dans lequel un matériau composite de polymère mélangé à des grains fins de métal est moulé par injection, la proportion de polymère est réduite par un chauffage du produit moulé, puis le produit ainsi obtenu est fritté et trempé.

10. Dispositif d'application de connecteur à ajustage à la presse, conformé pour un montage dans les trous traversants d'une carte de circuit imprimé (15) d'un connecteur de type à ajustage à la presse, ledit dispositif d'application comprenant un bloc de presse (35) selon une quelconque des revendications précédentes.
